# EUROPÄISCHE PATENTANMELDUNG

(11) **EP 0 878 846 A2**
(43) Veröffentlichungstag der Anmeldung: **18.11.1998**
(21) Anmeldenummer: 98106939.6
(22) Anmeldetag: 16.04.1998
(51) Int. Cl.: H01L 23/34

(54) **Übertemperaturschutzeinrichtung**

(30) Priorität: 16.05.1997 DE 19720610
(71) Anmelder: ABB PATENT GmbH, 68309 Mannheim (DE)
(72) Erfinder: Zapp, Robert, Dipl.-Ing., 58579 Schalksmühle (DE)
(74) Vertreter: Rupprecht, Klaus, Dipl.-Ing.

(57) **Zusammenfassung**

Die Erfindung bezieht sich auf eine Vorrichtung zum Schutz der Umgebung eines mit Anschlußbeinen (3, 4, 5) ausgestatteten Leistungstransistors (1) gegen Übertemperatur. Die Schutzvorrichtung besteht aus einer bandförmigen, elektrisch leitfähigen Bimetallfeder (2), die im Bereich laststromführender Anschlußbeine (3, 4) des Leistungstransistors (1) angeordnet werden kann. Die Bimetallfeder (2) hat einen vorzugsweise spiralförmig geformten Anfangsteil (6), mit dem sie gut wärmeleitend auf ein erstes laststromführendes Anschlußbein (3) aufsteckbar ist. Im montierten, kalten Zustand der Anordnung ist ein freies Ende (7) der Bimetallfeder (2) vom zweiten laststromführenden Anschlußbein (4) beabstandet. Die Bimetalleigenschaften der Bimetallfeder sind so gewählt, daß sich bei Übertemperatur des Leistungstransistors (1) ein freies Ende (7) der Bimetallfeder (2) zum zweiten laststromführenden Anschlußbein (4) hin bewegt, so daß die Anschlußbeine (3, 4) überbrückt sind.

## Beschreibung

Die Erfindung bezieht sich auf eine Schutzeinrichtung, die die Umgebung eines Leistungstransistors im Fall seines Defekts vor den Wirkungen einer Übertemperatur schützt.

Die Erfindung kann insbesondere in Dimmern zur Steuerung der Helligkeit von Beleuchtungseinrichtungen, aber auch in anderen, einen oder mehrere Leistungstransistoren aufweisenden Geräten angewendet werden.

Üblicherweise wird in solchen Geräten die in den Leistungstransistoren entstehende Verlustwärme mittels Kühlblechen abgeführt, um eine bestimmte Umgebungstemperatur für benachbarte Komponenten, z. B. eine Leiterplatte nicht zu überschreiten. Im Fall eines Transitorsdefekts kann dessen Innenwiderstand statt weniger als 1 Ohm auch mehrere Ohm annehmen. Die dadurch erheblich gesteigerte Verlustwärme kann nicht schnell genug über Kühlbleche abgeführt werden, wodurch die Temperatur in der unmittelbaren Umgebung des Leistungstransistors unzulässig hohe Werte annehmen kann. Insbesondere kann eine Leiterplatte, auf der der Leistungstransistor montiert ist, gefährdet sein.

Zur Vermeidung einer unzulässigen Übertemperatur ist es üblich, in solchen Geräten einen oder mehrere Thermoschalter anzuordnen, die je nach elektrischer Schaltung jeweils den Laststromkreis unterbrechen, oder den Transistor überbrücken. Ein solcher Thermoschalter wird üblicherweise auf ein Kühlblech oder an das Gehäuse des Transistors montiert.

Es hat sich gezeigt, daß im Fall eines Transistordefekts zuerst dessen Anschlußbeine sehr heiß werden und erst mit zeitlicher Verzögerung das Kühlblech oder das Gehäuse eine so hohe Temperatur annehmen, daß der Thermoschalter auslöst. Dadurch kann es bis zur Abschaltung durch einen Thermoschalter bereits zu Schäden in der Umgebung des Leistungstransistors, insbesondere an der Leiterplatte, gekommen sein.

Der Erfindung liegt daher die Aufgabe zugrunde, eine schneller wirkende, kostengünstigere und platzsparende Einrichtung zum Schutz der Umgebung eines Leistungstransistors vor Übertemperatur im Fall eines Transistordefekts anzugeben.

Diese Aufgabe wird bei einer Vorrichtung zum Schutz der Umgebung eines mit Anschlußbeinen ausgestatteten Leistungstransistors gegen Übertemperatur mit den im Anspruch 1 angegebenen Merkmalen gelöst.

Die Vorrichtung hat den Vorteil, daß sie aus nur einem besonders einfachen und robusten Bauteil besteht, das praktisch ohne besonderen Platzbedarf in ein Gerät einsetzbar ist.

Eine weitere Beschreibung der Schutzvorrichtung erfolgt nachstehend anhand eines in den Zeichnungsfiguren dargestellten Ausführungsbeispiels.

Es zeigen:
- Fig. 1: eine Anordnung eines Leistungstransistors auf einer Leiterplatte einschließlich einer Bimetallfeder als Schutzvorrichtung,
- Fig. 2: eine Ansicht auf die Unterseite eines Leistungstransistors mit aufgesteckter Bimetallfeder und
- Fig. 3: eine Bimetallfeder mit Schnappnase.

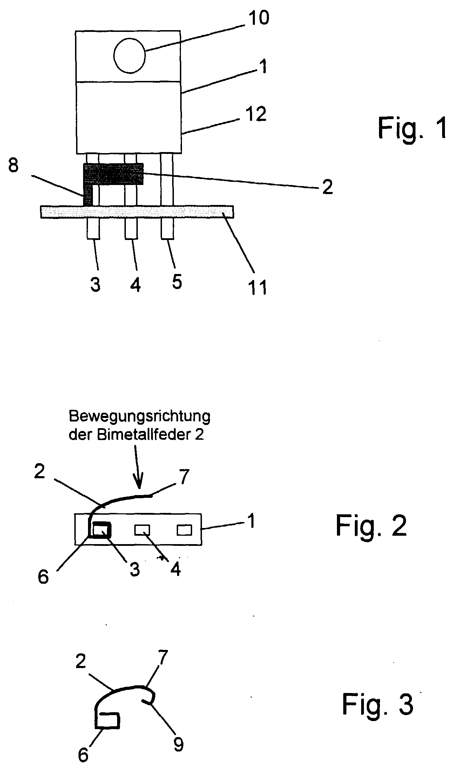

Fig. 1 zeigt einen mit einem Gehäuse versehenen Leistungstransistor 1, der Anschlußbeine 3, 4, 5 aufweist. Die ersten und zweiten Anschlüsse 3, 4 sind laststromführende Drain/Source-Anschlüsse. Mit 5 ist der Gate-Anschluß bezeichnet. Mit 10 ist ein Befestigungsloch am Transistorgehäuse 12 bezeichnet. Der Transistor 1 ist mittels seiner Anschlußbeine 3, 4, 5 auf einer Leiterplatte 11 montiert, wobei ein Abstand zwischen dem Gehäuse 12 und der Leiterplatte besteht.

In einem zwischen der Leiterplatte 11 und dem Gehäuse 12 des Leistungstransistors 1 verbliebenen Abstand ist eine Bimetallfeder 2 angeordnet. Eine an die Bimetallfeder 2 angeformte Stütze 8 bewirkt, daß eine bestimmte Position der Bimetallfeder 2 nahe am Transistorgehäuse 12 sichergestellt ist. Damit wird erreicht, daß die Bimetallfeder an der heißesten zugänglichen Stelle montiert ist.

Aus Fig. 2 ist in Verbindung mit Fig. 1 ersichtlich, daß die Bimetallfeder als schmales Band ausgeführt ist, das ein Anfangsteil 6 aufweist, das spiralförmig gebogen ist und das auf das erste laststromführende Anschlußbein 3 aufsteckbar ist. Durch geeignete Abmessungen und Verwendung eines federnden Materials wird erreicht, daß die Bimetallfeder 2 einen gut wärmeleitenden Kontakt zum Anschlußbein 3 hat. Die Bimetallfeder 2 weist ein freies Ende 7 auf, das im montierten Zustand einen Abstand zum zweiten laststromführenden Anschlußbein 4 hat. Bei einer den Normalbetrieb deutlich übersteigenden Temperatur des ersten Anschlußbeins 3 verformt sich die Bimetallfeder 2 soweit, daß sie mit ihrem freien Ende 7 das zweite laststromführende Anschlußbein 4 berührt.

Da die Bimetallfeder 2 bei Übertemperatur die Anschlußbeine 3, 4 überbrückt, fließt der Strom im wesentlichen durch die Bimetallfeder, wodurch sich der Leistungstransistor 1 im Innern abkühlt.

Die Bimetallfeder 2 kann je nach Bedarf unterschiedlich ausgestaltet werden. Durch die Wahl eines Materials mit geeigneten Bimetalleigenschaften und entsprechende Abmessungen der Bimetallfeder kann erreicht werden, daß der Laststrom die Bimetallfeder 2 soweit erwärmt, daß die Überbrückung der Anschlußbeine 3, 4 aufrechterhalten bleibt.

Fig. 3 zeigt eine Bimetallfeder 2, an derem freien Ende 7 eine Schnappnase 9 angeformt ist. Damit läßt sich erreichen, daß die Bimetallfeder 2 im Fall der Übertemperatur, sobald sie das zweite laststromführende Anschlußbein 4 berührt, dort mit der Schnappnase 9 einrastet. Die Anschlußbeine 3, 4 bleiben bei einer solchen Bimetallfederausführung nach einem Transistordefekt auch dann überbrückt, wenn der Laststrom abgeschaltet wird.

## Patentansprüche

1. Vorrichtung zum Schutz der Umgebung eines mit Anschlußbeinen (3, 4, 5) ausgestatteten Leistungstranssitors (1) vor einer Übertemperatur, dadurch gekennzeichnet, daß
a) als Schutzvorrichtung eine bandförmige, elektrisch leitfähige Bimetallfeder (2) im Bereich laststromführender Anschlußbeine (3, 4) angeordnet ist,
b) ein Anfangsteil (6) der Bimetallfeder (2) gut wärmeleitend an einem ersten laststromführenden Anschlußbein (3) befestigt ist,
c) ein freies Ende (7) der Bimetallfeder (2) beabstandet vom zweiten, zum selben Stromkreis gehörenden laststromführenden Anschlußbein (4) angeordnet ist
d) die Bimetalleigenschaft der Bimetallfeder (2) und der Abstand des freien Endes (7) der Bimetallfeder ('2) zum zweiten Anschlußbein (4) so gewählt sind, daß das freie Ende (7) der Bimetallfeder (2) das Zweite Anschlußbein (4) nur dann berührt, wenn eine durch Temperatur und Dauer bestimmte Übertemperatursituation besteht, wodurch die beiden laststromführenden Anschlußbeine (3, 4) durch die Bimetallfeder (2) elektrisch überbrückt werden.

2. Schutzvorrichtung nach Anspruch 1, dadurch gekennzeichnet, daß die Bimetallfeder (2) bezüglich der Werkstoffwahl und Abmessungen so gestaltet ist, daß ein nach der Berührung des zweiten Anschlußbeins (4) durch die Bimetallfeder (2) fließender Überbrückungsstrom genügt, die Bimetallfeder (2) zu erwärmen, um den Überbruckungszustand aufrechtzuerhalten.

3. Schutzvorrichtung nach Anspruch 1 oder 2, dadurch gekennzeichnet, daß das freie Ende (7) der Bimetallfeder (2) mit einer Schnappnase (9) versehen ist, die bewirkt, daß die sich verformende und das zweite Anschlußbein (4) berührende Bimetallfeder (2) sich mit der Schnappnase (9) am zweiten Anschlußbein (4) einhakt.

4. Schutzvorrichtung nach einem der vorstehenden Ansprüche, dadurch gekennzeichnet, daß an die Bimetallfeder (2) eine Stütze (8) angeformt ist, die eine Abstützung der Bimetallfeder (2) gegenüber einer Leiterplatte (11) ermöglicht.
